(19) **Europäisches Patentamt / European Patent Office / Office européen des brevets**

(11) **EP 4 576 491 A1**

(12) **EUROPEAN PATENT APPLICATION**
published in accordance with Art. 153(4) EPC

(43) Date of publication:
**25.06.2025 Bulletin 2025/26**

(21) Application number: **23901072.1**

(22) Date of filing: **05.12.2023**

(51) International Patent Classification (IPC):
*H02J 7/00* (2006.01)   *G01R 31/3835* (2019.01)
*G01R 31/389* (2019.01)   *H01M 10/44* (2006.01)
*B60L 53/62* (2019.01)

(52) Cooperative Patent Classification (CPC):
**B60L 53/62; G01R 31/3835; G01R 31/389;
H01M 10/44; H02J 7/00;** Y02E 60/10

(86) International application number:
**PCT/KR2023/019928**

(87) International publication number:
**WO 2024/123054 (13.06.2024 Gazette 2024/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **06.12.2022 KR 20220168437**

(71) Applicant: **LG Energy Solution, Ltd.
Seoul 07335 (KR)**

(72) Inventor: **KIM, Jong-Hun
Daejeon 34122 (KR)**

(74) Representative: **BCKIP Part mbB
MK1
Landsbergerstraße 98, 3.Stock
80339 München (DE)**

(54) **APPARATUS AND METHOD FOR CHARGING BATTERY**

(57)   A battery charging apparatus according to an embodiment of the present disclosure includes a current output unit configured to output a charging current to a battery during a preset charging time; a voltage measurement unit configured to measure a voltage of the battery; and a control unit configured to calculate a voltage change amount of the battery during the charging time, calculate a delay time according to the difference between the charging time and a criterion time preset to correspond to the voltage change amount, and set a charging condition corresponding to the battery based on the calculated delay time.

FIG. 1

EP 4 576 491 A1

# Description

## TECHNICAL FIELD

The present application claims priority to Korean Patent Application No. 10-2022-0168437 filed on December 6, 2022 in the Republic of Korea, the disclosures of which are incorporated herein by reference.

The present disclosure relates to a battery charging apparatus and method, and more particularly, to a battery charging apparatus and method capable of rapidly charging a battery.

## BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

As power driving devices such as electric vehicles, electric motorcycles, and electric bicycles are commercialized, the demand for high-capacity and high-performance batteries is increasing. However, as the capacity of the battery increases, the disadvantage that the time required to charge the battery also increases is highlighted. To solve this problem, technology for fast charging batteries is being developed.

However, in order to rapidly charge a battery, specific information about the charging target battery must be obtained. For example, prior information is needed regarding the specifications of the charging target battery, SOH (state of health), and allowable maximum charging C-rate. In the absence of such battery information, indiscriminate rapid charging may cause lithium to precipitate on the surface of the negative electrode of the battery (lithium plating, Li-plating). When lithium is precipitated on the surface of the negative electrode, it causes side reactions with the electrolyte and changes in the kinetic balance of the battery, resulting in battery deterioration. In addition, as lithium metal is precipitated on the surface of the negative electrode, an internal short circuit of the battery may occur, so there is a risk of ignition or explosion due to an internal short circuit.

Therefore, there is a need to develop technology that may safely quickly charge the battery even when there is no prior information about the battery by directly obtaining battery information.

## DISCLOSURE

### Technical Problem

The present disclosure is designed to solve the problems of the related art, and therefore the present disclosure is directed to providing a battery charging apparatus and method to safely and quickly charge a battery by obtaining battery information.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery charging apparatus according to one aspect of the present disclosure may comprise a current output unit configured to output a charging current to a battery during a preset charging time; a voltage measurement unit configured to measure a voltage of the battery; and a control unit configured to calculate a voltage change amount of the battery during the charging time, calculate a delay time according to the difference between the charging time and a criterion time preset to correspond to the voltage change amount, and set a charging condition corresponding to the battery based on the calculated delay time.

The control unit may be configured to determine a charging C-rate corresponding to the battery based on the delay time and set the determined charging C-rate as the charging condition.

The control unit may be configured to determine the charging C-rate corresponding to the delay time, based on a charging profile set to represent the corresponding relationship between the delay time and the charging C-rate.

The control unit may be configured to calculate a charging current amount during the charging time and calculate a resistance of the battery based on the voltage change amount and the charging current amount.

The control unit may be configured to set a criterion time preset to correspond to the resistance.

The control unit may be configured to determine the charging C-rate based on the delay time and the resistance.

When a charging profile set to represent the corresponding relationship between the delay time and the charging C-rate is set for each of a plurality of resistances, the control unit may be configured to select a charging profile corresponding to the resistance among the plurality of charging profiles and determine the charging C-rate corresponding to the delay time based on the selected charging profile.

The control unit may be configured to set a maximum C-rate corresponding to the delay time, set a threshold C-rate corresponding to the resistance, and determine a smaller value of the maximum C-rate and the threshold C-rate as the charging C-rate.

The control unit may be configured to set the maximum C-rate based on a first C-rate profile representing the corresponding relationship between the delay time and the maximum C-rate, and set the threshold C-rate based on a second C-rate profile representing the corresponding relationship between the resistance and the threshold C-rate.

The control unit may be configured to charge the battery according to the charging condition after the charging condition is set.

The control unit may be configured to calculate a fully charging time of the battery according to the charging condition.

The battery charging apparatus may further comprise a display unit configured to output at least one of the charging condition and the fully charging time.

A charging station according to still another aspect of the present disclosure may further comprise the battery charging apparatus according to one aspect of the present disclosure.

A battery charging method according to still another aspect of the present disclosure may comprise a charging current output step of outputting a charging current to a battery during a preset charging time; a voltage measurement step of measuring a voltage of the battery; a voltage change amount calculation step of calculating a voltage change amount of the battery during the charging time; a delay time calculation step of calculating a delay time according to the difference between the charging time and a criterion time preset to correspond to the voltage change amount; and a charging condition setting step of setting a charging condition corresponding to the battery based on the calculated delay time.

A battery charging method according to still another aspect of the present disclosure may further comprise a charging step of charging the battery according to the charging condition, after the charging condition setting step.

## Advantageous Effects

According to one aspect of the present disclosure, since the battery charging apparatus may set the charging C-rate corresponding to the connected battery in real time, it has the advantage of safely fast charging even a battery without prior information.

The effects of the present disclosure are not limited to the effects mentioned above, and other effects not mentioned will be clearly understood by those skilled in the art from the description of the claims.

## DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a diagram schematically showing a battery charging apparatus according to an embodiment of the present disclosure.

FIG. 2 is a diagram schematically showing an exemplary configuration of the battery charging apparatus according to an embodiment of the present disclosure.

FIG. 3 is a diagram schematically showing the charging current output by the battery charging apparatus according to an embodiment of the present disclosure.

FIG. 4 is a diagram schematically showing the voltage change of a battery according to an embodiment of the present disclosure.

FIG. 5 is a diagram schematically showing a voltage profile according to an embodiment of the present disclosure.

FIG. 6 is a diagram schematically showing a charging profile according to an embodiment of the present disclosure.

FIG. 7 is a diagram schematically showing a plurality of charging profiles according to an embodiment of the present disclosure.

FIG. 8 is a diagram schematically showing a first C-rate profile according to an embodiment of the present disclosure.

FIG. 9 is a diagram schematically showing a second C-rate profile according to an embodiment of the present disclosure.

FIGS. 10 and 11 are diagrams schematically showing a battery charging method according to another embodiment of the present disclosure.

## BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

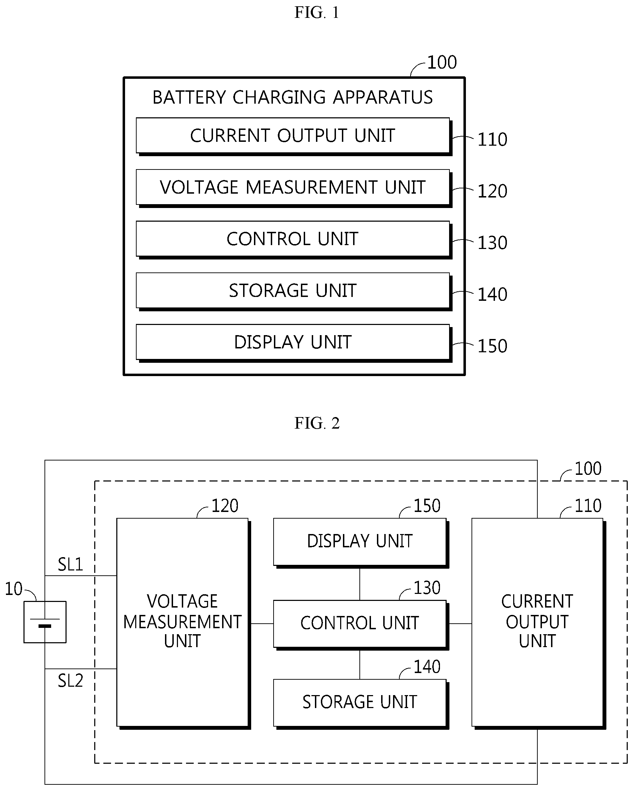

FIG. 1 is a diagram schematically showing a battery charging apparatus 100 according to an embodiment of the present disclosure. FIG. 2 is a diagram schematically showing an exemplary configuration of the battery charging apparatus 100 according to an embodiment of the present disclosure.

Referring to FIG. 1, the battery charging apparatus 100 may include a current output unit 110, a voltage measurement unit 120, and a control unit 130.

Here, the battery 10 refers to an independent cell that has a negative electrode terminal and a positive electrode terminal and is physically separable. As an example, a lithium-ion cell or a lithium polymer cell may be considered a battery. Additionally, the battery 10 may mean a battery module or battery pack that includes a plurality of cells.

The current output unit 110 may be configured to output a charging current to the battery during a preset charging time.

Specifically, the current output unit 110 may be connected to communicate with the control unit 130. The current output unit 110 may output a charging current during a preset charging time when receiving a current output signal from the control unit 130. For example, the charging time may be preset to a time of less than 1 second.

Here, the intensity of the charging current may be preset to a specific value. Preferably, the intensity of the charging current may be set to a specific value without considering the capacity of the battery.

For example, when the battery is connected to the battery charging apparatus 100, the control unit 130 may transmit a current output signal to the current output unit 110. When the current output unit 110 receives a current output signal, it may output a current of a preset intensity to the battery. That is, the current output unit 110 may charge the battery with a current of a preset intensity for a preset charging time.

For example, in the embodiment of FIG. 2, the current output unit 110 may be electrically connected to the positive electrode terminal and the negative electrode terminal of the battery 10. Also, when the current output unit 110 receives the current output signal from the control unit 130, it may output the charging current to the battery 10.

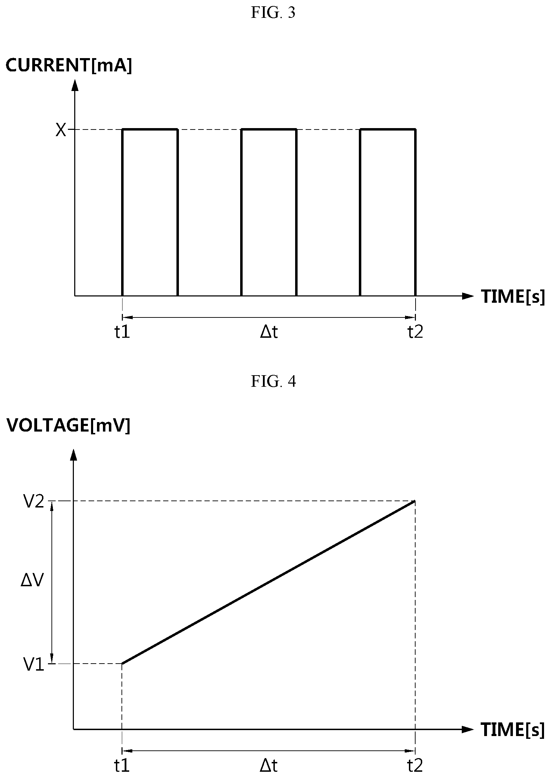

FIG. 3 is a diagram schematically showing the charging current output by the battery charging apparatus 100 according to an embodiment of the present disclosure.

In the embodiment of FIG. 3, the X-axis may represent the time at which the current is output, and the Y-axis may represent the intensity of the current. For example, assume that the current output unit 110 receives the current output signal from the control unit 130 at the time point t1. The current output unit 110 may output a current with an intensity of X (mA) during a preset charging time ($\Delta$t). Preferably, the current output unit 110 may output a pulse current with an intensity of X (mA) during the preset charging time ($\Delta$t). The current output unit 110 may output a charging current to the battery from the time point t1 to the time point t2.

The voltage measurement unit 120 may be configured to measure the voltage of the battery.

Specifically, the voltage measurement unit 120 may be configured to measure the voltage of the battery while the battery is being charged by a charging current.

In the embodiment of FIG. 2, while the current output unit 110 is charging the charging current to the battery 10, the voltage measurement unit 120 may measure the voltage of battery 10 using the first sensing line SL1 and the second sensing line SL2. Specifically, the voltage measurement unit 120 may measure the positive electrode potential of the battery 10 through the first sensing line SL1 and the negative electrode potential of the battery 10 through the second sensing line SL2. Additionally, the voltage measurement unit 120 may measure the voltage of the battery 10 by calculating the difference between the positive electrode potential and the negative electrode potential.

FIG. 4 is a diagram schematically showing the voltage change of a battery according to an embodiment of the present disclosure.

In the embodiment of FIG. 4, the voltage measurement unit 120 may measure the voltage of the battery during the charging time ($\Delta$t) during which the charging current is output. The battery voltage measured at the time point t1 may be V1, and the battery voltage measured at the time point t2 may be V2.

The embodiment of FIG. 3 shows an embodiment in which a pulse current is output during the charging time ($\Delta$t), but for convenience of explanation, it should be noted that the embodiment of FIG. 4 shows an embodiment in which a constant current is output during the charging time ($\Delta t$).

The control unit 130 may be configured to calculate the voltage change amount of the battery during the charging time.

Specifically, the voltage measurement unit 120 may be connected to enable communication with the control unit 130. The voltage measurement unit 120 may transmit the measured voltage information of the battery to the control unit 130. The control unit 130 may calculate the voltage change amount of the battery during the charging time according to the voltage information received from the voltage measurement unit 120. Here, the voltage change amount means the voltage increase amount of the battery according to the charging current output from the current output unit 110. That is, the control unit 130 may calculate the voltage increase amount of the battery during the charging time.

For example, in the embodiment of FIG. 4, the control unit 130 may receive voltage information during the charging time ($\Delta t$) from the voltage measurement unit 120. If the voltage measured at the time point t1 is V1 and the voltage measured at the time point t2 is V2, the control unit 130 may calculate the voltage change amount ($\Delta V$) by calculating the formula "V2 - V1".

As another example, in the embodiment of FIG. 4, the control unit 130 may only receive voltage information at the time point t1 and the time point t2 from the voltage measurement unit 120. Also, the control unit 130 may calculate the voltage change amount ($\Delta V$) by calculating "V2 - V1".

The control unit 130 may be configured to calculate a delay time based on the difference between the charging time and a criterion time preset to correspond to the voltage change amount.

Specifically, the control unit 130 may determine a criterion time preset to correspond to the voltage change amount. Then, the delay time may be obtained by calculating the difference between the determined criterion time and the charging time. Here, the charging time is the time during which the battery is charged by a charging current, and corresponds to $\Delta t$ in the embodiments of FIGS. 3 and 4.

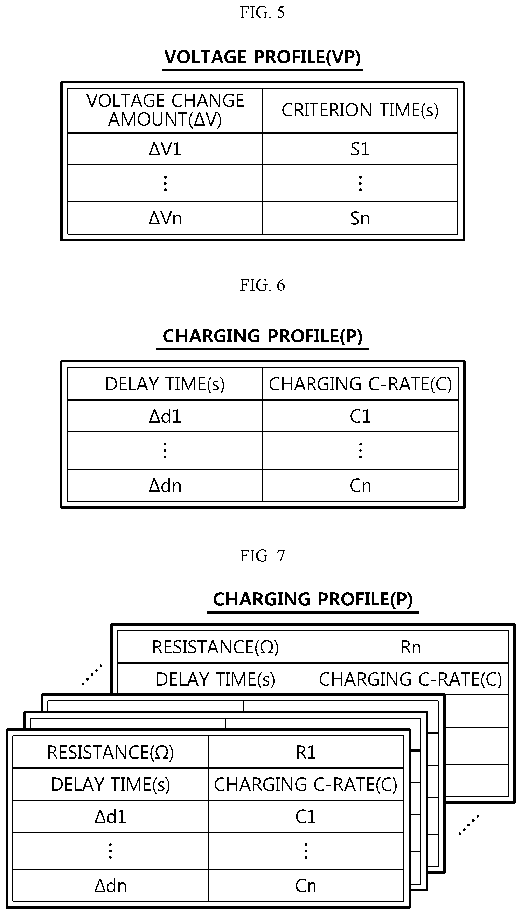

FIG. 5 is a diagram schematically showing a voltage profile VP according to an embodiment of the present disclosure.

In the embodiment of FIG. 5, the voltage profile VP may be preset to represent the corresponding relationship between the voltage change amount and the criterion time. The control unit 130 may determine a criterion time corresponding to the calculated voltage change amount based on the voltage profile VP.

For example, assume that the charging time is $\Delta t$. If the calculated voltage change amount is $\Delta V1$, the criterion time may be determined as S1. Additionally, the control unit 130 may calculate the delay time by calculating the difference between the criterion time (S1) and the measurement time ($\Delta t$).

For example, the control unit 130 may calculate the delay time by calculating the formula "measurement time - criterion time".

The control unit 130 may be configured to set the charging condition corresponding to the battery based on the calculated delay time.

Here, the charging condition may be a rapid charging condition corresponding to the battery. Specifically, the control unit 130 may be configured to determine the charging C-rate corresponding to the battery based on the delay time and set the determined charging C-rate as the charging condition.

That is, even if the control unit 130 does not receive separate information about the battery, it may determine the rapid charging C-rate for the battery based on the voltage change amount during the charging time and the calculated delay time.

More specifically, the control unit 130 may be configured to determine the charging C-rate corresponding to the delay time based on the charging profile P set to represent the corresponding relationship between the delay time and the charging C-rate.

FIG. 6 is a diagram schematically showing a charging profile P according to an embodiment of the present disclosure.

In the embodiment of FIG. 6, the charging profile P may be preset to represent the corresponding relationship between the delay time and the charging C-rate. The control unit 130 may determine the charging C-rate corresponding to the calculated delay time based on the charging profile P. That is, the control unit 130 may determine the charging C-rate that may rapidly charge the battery based on the delay time.

Also, after the charging condition is set, the current output unit 110 may be configured to charge the battery according to the charging condition.

The battery charging apparatus 100 according to an embodiment of the present disclosure has the advantage of being able to safely rapidly charge even a battery without prior information because it may set the charging C-rate corresponding to the connected battery in real time.

Meanwhile, the control unit 130 included in the battery charging apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 130 may be implemented as a set of program modules. At this time, the program module may be stored in the memory and executed by the control unit 130. The memory may be inside or outside the control unit 130 and may be connected to the control unit 130 by various well-known means.

In addition, the battery charging apparatus 100 may further include a storage unit 140. The storage unit 140 may store data necessary for operation and function of each component of the battery charging apparatus 100, data generated in the process of performing the operation or function, or the like. The storage unit 140 is not particularly limited in its kind as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

For example, the storage unit 140 may store the voltage profile VP and the charging profile P. The control unit 130 may access the storage unit 140 to obtain the voltage profile VP and the charging profile P. Additionally, the storage unit 140 may store the voltage of the battery 10 measured by the voltage measurement unit 120.

The control unit 130 may be configured to calculate the charging current amount during the charging time.

For example, the control unit 130 may calculate the charging current amount by multiplying the current intensity of the charging current output from the current output unit 110 by the charging time.

The control unit 130 may be configured to calculate the resistance of the battery based on the voltage change amount and the charging current amount.

Specifically, the control unit 130 may calculate the resistance according to the voltage change amount and the charging current amount based on Ohm's law. For example, the control unit 130 may calculate the resistance of the battery by calculating the formula "voltage change amount ÷ charging current amount".

Below, an embodiment of setting the charging condition using the resistance calculated by the control unit 130 will be described.

In one embodiment, the control unit 130 may be configured to set a criterion time preset to correspond to resistance.

Specifically, the criterion time may be set in advance not only for the voltage change amount but also for the resistance. Accordingly, the control unit 130 may set the criterion time corresponding to the resistance and calculate the delay time according to the difference between the criterion time and the measurement time. Additionally, the control unit 130 may set the charging condition of the battery based on the calculated delay time.

In another embodiment, the control unit 130 may be configured to determine the charging C-rate based on the delay time and the resistance.

If the charging profile P, which is set to represent the corresponding relationship between the delay time and the charging C-rate, is set for each of the plurality of resistances, the control unit 130 may be configured to select the charging profile P corresponding to the resistance among the plurality of charging profiles P.

Specifically, the charging profile P may be preset one by one for each of the plurality of resistances.

FIG. 7 is a diagram schematically showing a plurality of charging profiles P according to an embodiment of the present disclosure.

In the embodiment of FIG. 7, the charging profile P may be set in advance for each of the plurality of resistances (R1 to Rn). That is, a total of n charging profiles P may be set in advance.

The control unit 130 may select the charging profile P corresponding to the calculated resistance among the plurality of charging profiles P. For example, in the embodiment of FIG. 7, when the calculated resistance is R1, the control unit 130 may select the charging profile P corresponding to the R1 resistance.

The control unit 130 may be configured to determine the charging C-rate corresponding to the delay time based on the selected charging profile P.

Specifically, the control unit 130 may determine the charging C-rate for the battery by substituting the calculated delay time into the selected charging profile P. Also, the control unit 130 may set the determined charging C-rate as the charging condition of the battery. In this case, the current output unit 110 may charge the battery at the charging C-rate according to the set charging condition.

The battery charging apparatus 100 according to an embodiment of the present disclosure may determine a charging C-rate optimized for the battery by considering both the resistance and the delay time. Therefore, safe rapid charging of the battery may be performed to prevent lithium metal from precipitating.

In still another embodiment, the control unit 130 may be configured to set a maximum C-rate corresponding to the delay time.

Specifically, the control unit 130 may first set the maximum C-rate corresponding to the delay time, rather than directly setting the charging C-rate corresponding to the delay time. Here, the maximum C-rate is a value preset for the delay time and may mean the theoretical maximum value of C-rate that may be applied to the battery corresponding to the delay time.

Specifically, the control unit 130 may be configured to set the maximum C-rate based on the first C-rate profile CP1, which represents the corresponding relationship between the delay time and the maximum C-rate.

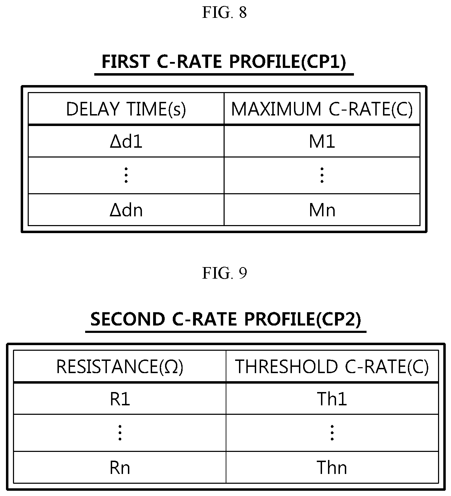

FIG. 8 is a diagram schematically showing a first C-rate profile CP1 according to an embodiment of the present disclosure. For example, the storage unit 140 may store the first C-rate profile CP1. The control unit 130 may access the storage unit 140 and obtain the first C-rate profile CP1.

In the embodiment of FIG. 8, the first C-rate profile CP1 may be preset to represent the corresponding relationship between the delay time and the maximum C-rate. The control unit 130 may determine the maximum C-rate corresponding to the calculated delay time based on the first C-rate profile CP1.

For example, if the delay time is $\Delta d1$, the maximum C-rate may be determined as M1.

The control unit 130 may be configured to set a threshold C-rate corresponding to the resistance.

Specifically, the control unit 130 may first set the threshold C-rate corresponding to the resistance, rather than directly setting the charging C-rate corresponding to the resistance. Here, the threshold C-rate is a value preset for the resistance and may mean the theoretical maximum value of C-rate that may be applied to the battery corresponding to the resistance.

Specifically, the control unit 130 may be configured to set the threshold C-rate based on the second C-rate profile CP2, which represents the corresponding relationship between the resistance and the threshold C-rate.

FIG. 9 is a diagram schematically showing a second C-rate profile CP2 according to an embodiment of the present disclosure. For example, the storage unit 140 may store the second C-rate profile CP2. The control unit 130 may access the storage unit 140 and obtain the second C-rate profile CP2.

In the embodiment of FIG. 9, the second C-rate profile CP2 may be preset to represent the corresponding relationship between the resistance and the threshold C-rate. The control unit 130 may determine the threshold C-rate corresponding to the calculated resistance based on the second C-rate profile CP2.

For example, if the resistance is R1, the threshold C-rate may be determined as Th1.

The control unit 130 may be configured to determine the smaller value of the maximum C-rate and the threshold C-rate as the charging C-rate.

Preferably, the maximum C-rate and the threshold C-rate may be independent values. In other words, the maximum C-rate is a C-rate corresponding to the delay time of the battery, and the threshold C-rate is a C-rate corresponding to the resistance of the battery. Therefore, the maximum C-rate and the threshold C-rate are independent from each other and may be compared by the control unit 130 for safer fast charging.

Generally, the higher the charging C-rate, the faster the battery can be charged. However, during the rapid charging process, stress is applied to the battery, and lithium metal may precipitate on the surface of the negative electrode. Therefore, determining the charging C-rate that may rapidly charge the battery while preventing precipitation of lithium metal is very important in terms of rapid charging and stability. The control unit 130 may set the charging condition that may safely and quickly charge the battery by determining the smaller value of the maximum C-rate and the threshold C-rate as the charging C-rate.

The control unit 130 may be configured to calculate the fully charging time of the battery according to the charging condition.

Specifically, when charging the battery with a set charging condition, the control unit 130 may calculate the fully charging time required for the battery to be fully charged. Preferably, the control unit 130 may calculate the fully charging time until the voltage of the battery reaches a preset charging end voltage.

For example, the control unit 130 may calculate the fully charging time until the battery voltage reaches a preset charging end voltage according to the charging C-rate, based on the voltage change amount according to the charging current during the charging time.

In one embodiment, the control unit 130 may calculate the fully charging time using the formula below.

[Formula 1]

$$\triangle V : (C_1 \times \triangle t) = (Vf - Vi) : (C_2 \times tc)$$

Here, Formula 1 can be arranged as Formula 2.

[Formula 2]

$$tc = (C_1 \times \triangle t) \times (Vf - Vi) \div (\triangle V \times C_2)$$

Here, $\triangle t$ is the charging time, $\triangle V$ is the voltage change amount during the charging time, and C1 is the charging current during the charging time converted to a C-rate value. For example, in the embodiment of FIGS. 3 and 4, the control unit 130 may calculate the voltage change amount ($\triangle V$) and then determine the capacity of the battery preset to correspond to the calculated voltage change amount ($\triangle V$). Also, the control unit 130 may convert the charging current (X) into a C-rate value by comparing the determined battery capacity and the charging current (X).

Additionally, Vf is the preset charging end voltage, and Vi is the current voltage of the battery. C2 is the charging C-rate determined by the control unit 130, and tc is the fully charging time. The control unit 130 may calculate the fully charging time (tc) based on Formula 1 and/or Formula 2.

Referring to FIG. 1, the battery charging apparatus 100 may further include a display unit 150 configured to output at least one of the charging condition and the fully charging time.

The display unit 150 may output the charging condition set by the control unit 130 and/or the fully charging time calculated by the control unit 130. Therefore, users may easily check under what charging condition the battery is charged and when the battery can be fully charged.

The battery charging apparatus 100 according to an embodiment of the present disclosure may be included in a charging station. That is, the charging station according to another embodiment of the present disclosure may include the battery charging apparatus 100 according to an embodiment of the present disclosure.

Specifically, the charging station is a station that may charge a battery. For example, the charging station may charge portable batteries as well as batteries included in transportation such as electric vehicles, electric motorcycles, and electric bicycles. More specifically, the charging station may be a charging station that can charge a battery.

Preferably, the charging station may include one or more battery charging apparatuses 100. For example, the charging station may include one or more terminals, and each terminal may include the battery charging apparatus 100. Additionally, the battery electrically connected to the battery charging apparatus 100 may be charged according to an embodiment of the present disclosure.

According to an embodiment of the present disclosure, there is an advantage that even batteries without prior information can be safely and quickly charged at a charging station.

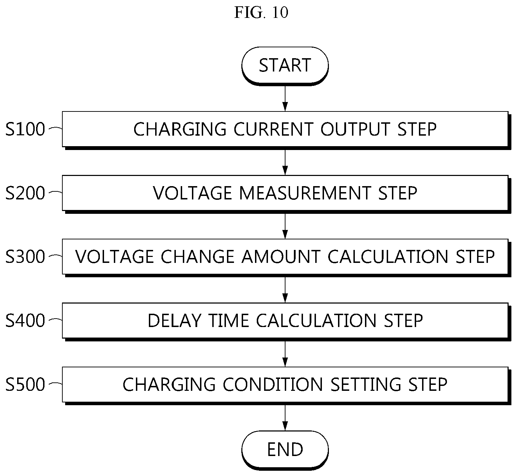

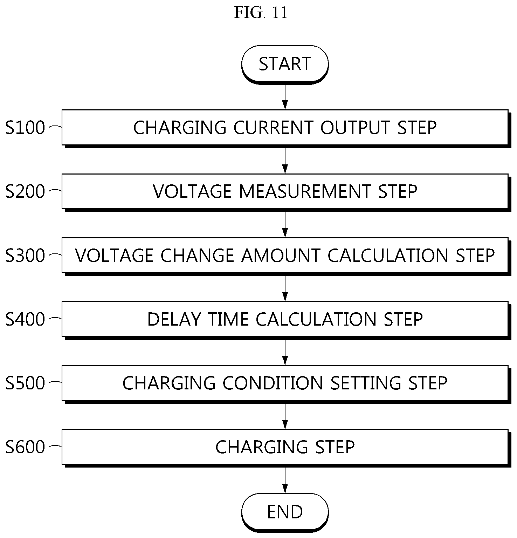

FIGS. 10 and 11 are diagrams schematically showing a battery charging method according to another embodiment of the present disclosure.

Preferably, each step of the battery charging method may be performed by the battery charging apparatus 100. Hereinafter, for convenience of explanation, content that overlaps with the content described above will be omitted or briefly described.

Referring to FIG. 10, the battery charging method may include a charging current output step (S100), a voltage measurement step (S200), a voltage change amount calculation step (S300), a delay time calculation step (S400), and a charging condition setting step (S500).

The charging current output step (S100) is a step of outputting a charging current to a battery during a preset charging time, and may be performed by the current output unit 110.

For example, when the battery charging apparatus 100 and the battery are connected, the current output unit 110 may receive a current output signal from the control unit 130. The current output unit 110 may output a charging current of a preset intensity to the battery during a preset charging time from the time point at which the current output signal is received.

The voltage measurement step (S200) is a step of measuring a voltage of the battery, and may be performed by the voltage measurement unit 120.

For example, the voltage measurement unit 120 may measure the voltage of the battery during a charging time.

The voltage change amount calculation step (S300) is a step of calculating a voltage change amount of the battery during the charging time, and may be performed by the control unit 130.

For example, the control unit 130 may calculate the voltage change amount by calculating the difference between the voltage at the time point when charging begins and the voltage at the time point when charging ends. That is, the control unit 130 may calculate the voltage change amount of the battery according to the charging current amount applied during the charging time.

For example, in the embodiment of FIG. 4, the control unit 130 may calculate the voltage change amount ($\Delta V$) during the charging time ($\Delta t$).

The delay time calculation step (S400) is a step of calculating a delay time according to the difference between the charging time and a criterion time preset to correspond to the voltage change amount, and may be performed by the control unit 130.

For example, in the embodiment of FIG. 5, the control unit 130 may first determine the criterion time corresponding to the voltage change amount ($\Delta V$) based on the voltage profile VP. Additionally, the delay time may be calculated based on the difference between the charging time ($\Delta t$) and the criterion time. Here, the criterion time is the theoretical time corresponding to the voltage change amount, and the charging time is the time when the charging current is actually applied. Therefore, the control unit 130 may calculate the delay time for the voltage change of the battery by calculating the difference between the charging time and the criterion time.

The charging condition setting step (S500) is a step of setting a charging condition corresponding to the battery based on the calculated delay time, and may be performed by the control unit 130.

Since the delay time reflects the state of the battery, the control unit 130 may set the charging condition corresponding to the battery according to the delay time even if prior information about the battery is not secured.

For example, in the embodiment of FIG. 6, the control unit 130 may determine a charging C-rate corresponding to the delay time based on the charging profile P. Also, the control unit 130 may set the charging C-rate as the charging condition for the battery.

Referring to FIG. 11, the battery charging method may further include a charging step (S600).

The charging step (S600) is a step of charging the battery according to the charging condition after the charging condition setting step (S500), and may be performed by the current output unit 110.

For example, when the charging condition of the battery is set by the control unit 130, the current output unit 110 may rapidly charge the battery with the set charging condition (specifically, the set charging C-rate).

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

(Explanation of reference signs)

    10: battery
    100: battery charging apparatus
    110: current output unit
    120: voltage measurement unit
    130: control unit
    140: storage unit
    150: display unit

**Claims**

1. A battery charging apparatus, comprising:

    a current output unit configured to output a charging current to a battery during a preset charging time;
    a voltage measurement unit configured to measure a voltage of the battery; and
    a control unit configured to calculate a voltage change amount of the battery during the charging time, calculate a delay time according to the difference between the charging time and a criterion time preset to correspond to the voltage change amount, and set a charging condition corresponding to the battery based on the calculated delay time.

2. The battery charging apparatus according to claim 1, wherein the control unit is configured to determine a charging C-rate corresponding to the battery based on the delay time and set the determined charging C-rate as the charging condition.

3. The battery charging apparatus according to claim 2, wherein the control unit is configured to determine the charging C-rate corresponding to the delay time, based on a charging profile set to represent the corresponding relationship between the delay time and the charging C-rate.

4. The battery charging apparatus according to claim 2, wherein the control unit is configured to calculate a charging current amount during the charging time and calculate a resistance of the battery based on the voltage change amount and the charging current amount.

5. The battery charging apparatus according to claim 4, wherein the control unit is configured to set a criterion time preset to correspond to the resistance.

6. The battery charging apparatus according to claim 4, wherein the control unit is configured to determine the charging C-rate based on the delay time and the resistance.

7. The battery charging apparatus according to claim 6, wherein when a charging profile set to represent the corresponding relationship between the delay time and the charging C-rate is set for each of a plurality of resistances, the control unit is configured to select a charging profile corresponding to the resistance among the plurality of charging profiles and determine the charging C-rate corresponding to the delay time based on the selected charging profile.

8. The battery charging apparatus according to claim 4, wherein the control unit is configured to set a maximum C-rate corresponding to the delay time, set a threshold C-rate corresponding to the resistance, and determine a smaller value of the maximum C-rate and the threshold C-rate as the charging C-rate.

9. The battery charging apparatus according to claim 8, wherein the control unit is configured to set the maximum C-rate based on a first C-rate profile representing the corresponding relationship between the delay time and the maximum C-rate, and set the threshold C-rate based on a second C-rate profile representing the corresponding relationship between the resistance and the threshold C-rate.

10. The battery charging apparatus according to claim 1, wherein the current output unit is configured to charge the battery according to the charging condition after the charging condition is set.

11. The battery charging apparatus according to claim 1,

    wherein the control unit is configured to calculate a fully charging time of the battery according to the charging condition, and
    wherein the battery charging apparatus further comprises a display unit configured to output at least one of the charging condition and the fully charging time.

12. A charging station, comprising the battery charging apparatus according to any one of claims 1 to 11.

13. A battery charging method, comprising:

a charging current output step of outputting a charging current to a battery during a preset charging time;
a voltage measurement step of measuring a voltage of the battery;
a voltage change amount calculation step of calculating a voltage change amount of the battery during the charging time;
a delay time calculation step of calculating a delay time according to the difference between the charging time and a criterion time preset to correspond to the voltage change amount; and
a charging condition setting step of setting a charging condition corresponding to the battery based on the calculated delay time.

14. The battery charging method according to claim 13, further comprising a charging step of charging the battery according to the charging condition, after the charging condition setting step.

FIG. 1

```
                                               ┌─ 100
┌─────────────────────────────────────────────┐
│           BATTERY CHARGING APPARATUS         │
│  ┌───────────────────────────────────────┐   │
│  │         CURRENT OUTPUT UNIT            │───── 110
│  └───────────────────────────────────────┘   │
│  ┌───────────────────────────────────────┐   │
│  │       VOLTAGE MEASUREMENT UNIT         │───── 120
│  └───────────────────────────────────────┘   │
│  ┌───────────────────────────────────────┐   │
│  │            CONTROL UNIT                │───── 130
│  └───────────────────────────────────────┘   │
│  ┌───────────────────────────────────────┐   │
│  │            STORAGE UNIT                │───── 140
│  └───────────────────────────────────────┘   │
│  ┌───────────────────────────────────────┐   │
│  │            DISPLAY UNIT                │───── 150
│  └───────────────────────────────────────┘   │
└─────────────────────────────────────────────┘
```

FIG. 2

```
                                                          ┌─ 100
┌──────────────────────────────────────────────────────────────────┐
│  ┌───────────────────────────────────────────────────────────┐   │
│  │      ┌─ 120           ┌─ 150              ┌─ 110           │   │
│  │  ┌──────────┐    ┌─────────────┐    ┌──────────────┐       │   │
│SL1 │ │          │    │ DISPLAY UNIT│    │              │       │   │
│────┼─│          │    └─────────────┘    │              │       │   │
│10  │ │ VOLTAGE  │         ┌─ 130         │   CURRENT    │       │   │
│──│ │ │MEASUREMENT│   ┌─────────────┐    │   OUTPUT     │       │   │
│─── │ │  UNIT    │───│ CONTROL UNIT│────│    UNIT      │       │   │
│SL2 │ │          │    └─────────────┘    │              │       │   │
│────┼─│          │         ┌─ 140         │              │       │   │
│    │ │          │    ┌─────────────┐    │              │       │   │
│    │ └──────────┘    │ STORAGE UNIT│    └──────────────┘       │   │
│    │                 └─────────────┘                           │   │
│  └───────────────────────────────────────────────────────────┘   │
└──────────────────────────────────────────────────────────────────┘
```

FIG. 3

CURRENT[mA]

X

TIME[s]

t1    Δt    t2

FIG. 4

VOLTAGE[mV]

V2

ΔV

V1

TIME[s]

t1    Δt    t2

FIG. 5

## VOLTAGE PROFILE(VP)

| VOLTAGE CHANGE AMOUNT(ΔV) | CRITERION TIME(s) |
|---|---|
| ΔV1 | S1 |
| ⋮ | ⋮ |
| ΔVn | Sn |

FIG. 6

## CHARGING PROFILE(P)

| DELAY TIME(s) | CHARGING C-RATE(C) |
|---|---|
| Δd1 | C1 |
| ⋮ | ⋮ |
| Δdn | Cn |

FIG. 7

## CHARGING PROFILE(P)

| RESISTANCE(Ω) | Rn |
|---|---|
| DELAY TIME(s) | CHARGING C-RATE(C) |

| RESISTANCE(Ω) | R1 |
|---|---|
| DELAY TIME(s) | CHARGING C-RATE(C) |
| Δd1 | C1 |
| ⋮ | ⋮ |
| Δdn | Cn |

FIG. 8

## FIRST C-RATE PROFILE(CP1)

| DELAY TIME(s) | MAXIMUM C-RATE(C) |
|:---:|:---:|
| Δd1 | M1 |
| ⋮ | ⋮ |
| Δdn | Mn |

FIG. 9

## SECOND C-RATE PROFILE(CP2)

| RESISTANCE(Ω) | THRESHOLD C-RATE(C) |
|:---:|:---:|
| R1 | Th1 |
| ⋮ | ⋮ |
| Rn | Thn |

FIG. 10

```
                          ┌─────────┐
                          │  START  │
                          └─────────┘
                               │
                               ▼
  S100 ─┌──────────────────────────────────────────────┐
        │        CHARGING CURRENT OUTPUT STEP           │
        └──────────────────────────────────────────────┘
                               │
                               ▼
  S200 ─┌──────────────────────────────────────────────┐
        │          VOLTAGE MEASUREMENT STEP             │
        └──────────────────────────────────────────────┘
                               │
                               ▼
  S300 ─┌──────────────────────────────────────────────┐
        │    VOLTAGE CHANGE AMOUNT CALCULATION STEP     │
        └──────────────────────────────────────────────┘
                               │
                               ▼
  S400 ─┌──────────────────────────────────────────────┐
        │         DELAY TIME CALCULATION STEP           │
        └──────────────────────────────────────────────┘
                               │
                               ▼
  S500 ─┌──────────────────────────────────────────────┐
        │       CHARGING CONDITION SETTING STEP         │
        └──────────────────────────────────────────────┘
                               │
                               ▼
                          ┌─────────┐
                          │   END   │
                          └─────────┘
```

FIG. 11

START

S100 — CHARGING CURRENT OUTPUT STEP

S200 — VOLTAGE MEASUREMENT STEP

S300 — VOLTAGE CHANGE AMOUNT CALCULATION STEP

S400 — DELAY TIME CALCULATION STEP

S500 — CHARGING CONDITION SETTING STEP

S600 — CHARGING STEP

END

## INTERNATIONAL SEARCH REPORT

| International application No. |
|---|
| **PCT/KR2023/019928** |

| A. | CLASSIFICATION OF SUBJECT MATTER |
|---|---|

**H02J 7/00**(2006.01)i; **G01R 31/3835**(2019.01)i; **G01R 31/389**(2019.01)i; **H01M 10/44**(2006.01)i; **B60L 53/62**(2019.01)i

According to International Patent Classification (IPC) or to both national classification and IPC

| B. | FIELDS SEARCHED |
|---|---|

Minimum documentation searched (classification system followed by classification symbols)

H02J 7/00(2006.01); G01R 31/36(2006.01); H01M 10/052(2010.01); H01M 10/48(2006.01); H01M 4/587(2010.01); H02J 7/10(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 충전(charging), 지연 시간(delay time), 전압(voltage)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2019-0095755 A (LG CHEM, LTD.) 16 August 2019 (2019-08-16) See paragraphs [0031], [0046]-[0049] and [0192]; and figures 1 and 11. | 1-4,6-7,10-14 |
| A | | 5,8-9 |
| Y | JP 2018-196248 A (MITSUBISHI MOTORS CORP.) 06 December 2018 (2018-12-06) See paragraphs [0013]-[0020]. | 1-4,6-7,10-14 |
| Y | JP 2017-163739 A (TOYOTA MOTOR CORP.) 14 September 2017 (2017-09-14) See paragraphs [0032]-[0038] and [0055]. | 4,6-7 |
| Y | KR 10-2017-0086876 A (LG CHEM, LTD.) 27 July 2017 (2017-07-27) See paragraph [0110]. | 7 |
| A | JP 2015-012652 A (TOYOTA INDUSTRIES CORP.) 19 January 2015 (2015-01-19) See entire document. | 1-14 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **06 March 2024** | **06 March 2024** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2023/019928**

| Patent document cited in search report | | | Publication date (day/month/year) | Patent family member(s) | | | Publication date (day/month/year) |
|---|---|---|---|---|---|---|---|
| KR | 10-2019-0095755 | A | 16 August 2019 | CN | 110770593 | A | 07 February 2020 |
| | | | | CN | 110770593 | B | 07 January 2022 |
| | | | | EP | 3674727 | A1 | 01 July 2020 |
| | | | | EP | 3674727 | B1 | 29 December 2021 |
| | | | | EP | 3674727 | B8 | 09 February 2022 |
| | | | | JP | 2020-524969 | A | 20 August 2020 |
| | | | | JP | 6859584 | B2 | 14 April 2021 |
| | | | | PL | 3674727 | T3 | 21 February 2022 |
| | | | | US | 11121571 | B2 | 14 September 2021 |
| | | | | US | 2020-0195017 | A1 | 18 June 2020 |
| | | | | WO | 2019-156385 | A1 | 15 August 2019 |
| JP | 2018-196248 | A | 06 December 2018 | None | | | |
| JP | 2017-163739 | A | 14 September 2017 | CN | 107181312 | A | 19 September 2017 |
| | | | | CN | 107181312 | B | 23 June 2020 |
| | | | | CN | 111431261 | A | 17 July 2020 |
| | | | | CN | 111431261 | B | 10 November 2023 |
| | | | | DE | 102017104833 | A1 | 14 September 2017 |
| | | | | DE | 102017104833 | B4 | 14 July 2022 |
| | | | | JP | 6508094 | B2 | 08 May 2019 |
| | | | | US | 10135264 | B2 | 20 November 2018 |
| | | | | US | 10601230 | B2 | 24 March 2020 |
| | | | | US | 2017-0264104 | A1 | 14 September 2017 |
| | | | | US | 2019-0044344 | A1 | 07 February 2019 |
| KR | 10-2017-0086876 | A | 27 July 2017 | US | 10734688 | B2 | 04 August 2020 |
| | | | | US | 2017-0207497 | A1 | 20 July 2017 |
| JP | 2015-012652 | A | 19 January 2015 | JP | 6060831 | B2 | 18 January 2017 |

Form PCT/ISA/210 (patent family annex) (July 2022)

**EP 4 576 491 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220168437